# EUROPÄISCHE PATENTSCHRIFT

(11) **EP 0 945 950 B1**
(45) Veröffentlichungstag und Bekanntmachung des Hinweises auf die Patenterteilung: **23.07.2003**
(21) Anmeldenummer: 98118529.1
(22) Anmeldetag: 30.09.1998
(51) Int. Cl.: H02H 3/00, H02H 3/093

(54) **Verfahren und Vorrichtung zur Ansteuerung eines Verbrauchers**
Method and apparatus for controlling a load
Procedé et dispositif pour contrôler une charge

(30) Priorität: 25.03.1998 DE 19813103
(43) Veröffentlichungstag der Anmeldung: 29.09.1999
(73) Patentinhaber: ROBERT BOSCH GMBH, 70442 Stuttgart (DE)
(72) Erfinder: Zimmermann, Christian, 72072 Tuebingen (DE)

(56) Entgegenhaltungen:
- EP-A- 0 343 536
- FR-A- 2 696 054
- PATENT ABSTRACTS OF JAPAN vol. 1997, no. 04, 30. April 1997 (1997-04-30) & JP 08 335434 A (NITTO KOGYO KK), 17. Dezember 1996 (1996-12-17)

## Beschreibung

### Stand der Technik

Die Erfindung betrifft ein Verfahren und eine Vorrichtung zur Ansteuerung eines Verbrauchers gemäß den Oberbegriffen der unabhängigen Ansprüche.

Aus der EP 0 343 536 ist ein Verfahren und eine Vorrichtung zur Ansteuerung von Verbrauchern bekannt. Zur Ansteuerung des Verbrauchers wird eine Endstufe verwendet. Bei einem Kurzschluss zwischen der Endstufe und einer Masse bzw. zwischen der Endstufe und einer Versorgungsspannung können sehr hohe Kurzschlussströme auftreten. Tritt ein solcher Kurzschluss auf, so wird die weitere Ansteuerung des Verbrauchers für eine vorgebbare Zeit unterbunden.

Hierzu sind verschiedene Vorgehensweisen bekannt. So kann eine Regelung des Kurzschlußstroms vorgesehen sein, des weiteren ist eine Kurzschlußabschaltung oder eine Überwachung durch ein ansteuerndes Bauelement über eine Statusrückmeldung von der Endstufe möglich. Dabei wird zwischen Endstufen, die sich selbst schützen (Eigenintelligenz) und Endstufen, die durch Fremdintelligenz beispielsweise in einem Mikroprozessor geschützt werden, unterschieden.

Dabei ist häufig vorgesehen, daß die Endstufe einen Schaltungsteil besitzt, der im ersten Augenblick des Kurzschlusses den Strom, der durch die Endstufe fließt, auf zulässige Werte begrenzt. Da im Stromregelbetrieb eine hohe Verlustleistung an der Endstufe auftritt, wird diese im allgemeinen zwangsweise abgeschaltet.

Um eine Fehlabschaltung, beispielsweise beim Entladen von kapazitiven Lasten oder kurzen Spannungsspitzen, zu verhindern, wird die Abschaltung erst nach einer Entprellzeit von beispielsweise 100 Mikrosekunden durchgeführt. Das Wiedereinschalten der Endstufe erfolgt selbständig bei der nächsten Ansteuerflanke des Ansteuersignals.

Folgt bei einem vorliegenden Kurzschluß direkt nach der Zwangsabschaltung ein Einschaltsignal, so wird sofort wieder in den Stromregelbetrieb mit sehr hohen Verlustleistungen geschaltet, d. h. bei entsprechend schnellen Ansteuersignalen wird ständig ein hohe mittlere Verlustleistung in der Endstufe erzeugt. Die Endstufe kann trotz Kurzschlußschutz thermisch zerstört werden.

Es ist bekannt, daß eine feste Pause eingefügt wird, um eine thermische Zerstörung zu verhindern, in der die Endstufe nach einem Kurzschluß nicht mehr eingeschaltet werden kann. Nachteilig an dieser Lösung ist, daß die Systemverfügbarkeit der Endstufe bereits bei einem nur kurz anliegenden Kurzschluß unter Umständen für eine unnötig lange Zeit nicht mehr gegeben ist.

Desweiteren kann vorgesehen sein, daß die Verlustleistung in Abhängigkeit der Chiptemperatur zurückgenommen wird. Diese Lösung hat verschiedene Nachteile. Der Eingriff darf erst oberhalb von der im Normalbetrieb maximal zulässigen Temperatur, beispielsweise von 150 Grad Celsius, erfolgen. Der Eingriff ist schlecht prüfbar. Der Kurzschlußbetrieb beeinträchtigt wegen der hohen Temperatur die Zuverlässigkeit der Endstufe. Die Wiederverfügbarkeit nach Entfall des Kurzschlusses tritt auf Grund der thermischen Zeitkonstante unter Umständen mit Verzögerung ein.

Die FR 2696054 zeigt eine sogenannte Fehlerstromschutzschaltung, bei der der Stromfluss unterbrochen ist, wenn die Ströme in einer Hin- und einer Rückleitung zwischen einem Verbraucher und einer Spannungsquelle um mehr als einen bestimmten Wert voneinander abweichen.

### Aufgabe der Erfindung

Der Erfindung liegt die Aufgabe zu Grunde, bei einem Verfahren und einer Vorrichtung zur Ansteuerung eines Verbrauchers eine hohe Verfügbarkeit der Endstufe bei gleichzeitig gutem Kurzschlußschutz erzielen zu können. Diese Aufgabe wird durch die in den unabhängigen Ansprüchen gekennzeichneten Merkmale gelöst.

### Vorteile der Erfindung

Mit der erfindungsgemäßen Vorgehensweise ergibt sich eine kurzschlußfeste Endstufe. Die Nichtverfügbarkeit der Endstufe orientiert sich an der tatsächlichen Belastung der Endstufe im Fehlerfall. Sporadische Kurzschlüsse führen nur zu einer minimalen Nichtverfügbarkeit der Endstufe. Die thermische Belastung der Endstufe ist minimiert. Die Schaltung besteht im wesentlichen aus einer einfachen Logik und ist in den heute verwendeten Prozessoren ohne großen Aufwand zu realisieren.

Vorteilhafte und zweckmäßige Ausgestaltungen und Weiterbildungen der Erfindung sind in den Unteransprüchen gekennzeichnet.

### Zeichnung

Die Erfindung wird nachstehend an Hand der in der Zeichnung dargestellten Ausführungsformen erläutert. Es zeigen Figur 1 ein Blockdiagramm der erfindungsgemäßen Vorrichtung, Figur 2 ein Flußdiagramm und Figur 3 verschiedene Signale über der Zeit aufgetragen.

### Beschreibung der Ausführungsbeispiele

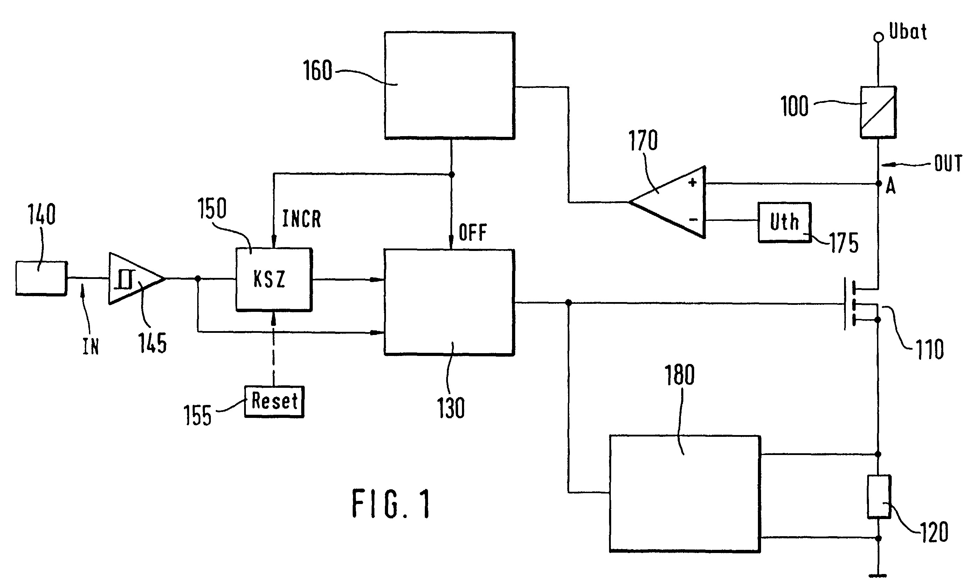

In Figur 1 ist die erfindungsgemäße Vorrichtung an Hand eines Blockdiagrammes dargestellt. Ein Verbraucher ist mit 100 bezeichnet. Dieser ist mit seinem einen Anschluß unmittelbar mit einer Versorgungsspannung Ubat verbunden. Mit seinem zweiten Anschluß steht er über ein Schaltmittel 110 und über ein Strommeßmittel 120 mit Masse in Verbindung.

Solche Verbraucher werden insbesondere in Kraftfahrzeugen für vielfältige Aufgaben eingesetzt. So kann es sich bei dem Verbraucher 100 beispielsweise um ein Magnetventil handeln, das zur Steuerung der Kraftstoffzumessung dient. Die erfindungsgemäße Vorgehensweise ist aber nicht auf Magnetventile beschränkt, sie kann prinzipiell bei allen Verbrauchern insbesondere in Kraftfahrzeugen eingesetzt werden.

Die Reihenfolge des Verbrauchers 100, des Schaltmittel 110 und des Strommeßmittels 120 ist nur beispielhaft gewählt. Es kann auch vorgesehen sein, daß das Schaltmittel 110 zwischen Versorgungsspannung und dem Verbraucher 100 geschaltet ist. Ferner kann vorgesehen sein, daß ein zweites Schaltmittel zwischen Verbraucher und Masse geschaltet ist.

Das Schaltmittel 110 wird von einer Logik 130 mit Ansteuersignalen beaufschlagt. Die Logik steht wiederum über ein Verstärker 145 mit einem Mikroprozessor 140 in Verbindung Der Mikroprozessor 140 dient beispielsweise zur Steuerung der Leistungsabgabe der Brennkraftmaschine und gibt abhängig von verschiedenen Betriebskenngrößen der Brennkraftmaschine ein Signal IN zur Ansteuerung des Schaltmittels und damit des Verbrauchers 100 vor.

Des weiteren gelangt das Ausgangssignal des Verstärkers 145 über ein Kurzschlußzähler 150 zur Logik 130. Der Kurzschlußzähler 150 steht ferner mit einer Resetvorgabe 155 und einer Verzögerung 160 in Verbindung. Die Verzögerung 160 beaufschlagt ferner die Logik 130 mit dem entsprechenden Signal. Die Verzögerung 160 verarbeitet das Ausgangssignal einer Kurzschlußerkennung 170 deren erster Eingang mit dem Verbindungspunkt A zwischen dem Verbraucher 100 und dem Schaltmittel 110 in Verbindung steht. Der zweite Eingang der Kurzschlußerkennung 170 steht mit einer Vergleichswertvorgabe 175 in Kontakt.

Alternativ kann auch vorgesehen sein, daß die Funktion der Kurzschlußerkennung von der Strombegrenzung 180 übernommen wird. Dies bedeutet, daß die Strombegrenzung 180 beim Überschreiten eines entsprechenden Schwellwerts ein dem Ausgangssignal der Kurzschlßerkennung entsprechendes Signal an die Verzögerung 160 liefert.

Die Ausgänge des Strommeßwiderstandes 120 werden einer Kurzschlußstrombegrenzung 180 zugeführt, die ebenfalls den Steuereingang des Schaltmittels 110 mit Signalen beaufschlagt.

Die Arbeitsweise dieser Vorrichtung wird im Folgenden am Beispiel der Steuerung eines Einspritzventils bei einer Brennkraftmaschine beschrieben.

Ausgehend von verschiedenen Betriebskenngrößen berechnet der Mikroprozessor 140 ein Ansteuersignal IN zur Ansteuerung des Schaltmittels 110. Dieses Ansteuersignal bestimmt die einzuspritzende Kraftstoffmenge. Bei einem ersten Pegel des Signals gibt das Schaltmittel 110 den Stromfluß durch den Verbraucher frei. Bei einem zweiten Pegel des Signals wird der Stromfluß durch den Verbraucher unterbrochen.

Tritt nun ein Kurzschluß zwischen dem Schaltmittel 110 und der Batteriespannung Ubat auf, so fließt bei geschlossenem Schaltmittel 110 ein wesentlich größerer Strom durch das Schaltmittel, da der Widerstand zwischen Verbindungspunkt A und der Versorgungsspannung zu 0 wird.

Um einen solchen Kurzschluß zu erkennen, ist beispielsweise die Kurzschlußerkennung 170 vorgesehen, die ausgehend von der Spannung, die am Verbindungspunkt A zwischen Verbraucher 100 und dem Schaltmittel 110 anliegt, einen Kurzschluß erkennt. Hierzu ist die Kurzschlußerkennung 170 beispielsweise, wie in Figur 1 dargestellt, als Vergleicher ausgebildet. Die Kurzschlußerkennung 170 vergleicht die Spannung am Verbindungspunkt A mit einem Wert Uth, der von der Vergleichswertvorgabe 175 vorgegeben wird. Weicht der Wert der Spannung am Verbindungspunkt A von dem erwarteten Wert Uth ab, so gibt die Kurzschlußerkennung 170 ein Signal ab, das einen Kurzschluß anzeigt. Dieses Signal wird in der Verzögerung 160 für eine vorgegebene Zeit beispielsweise für 100 Mikrosekunden verzögert. Nach Ablauf dieser Verzögerungszeit gibt die Verzögerung 160 ein Signal an die Logik 130, das einen Kurzschluß anzeigt. Erkennt die Kurzschlußerkennung innerhalb dieser Verzögerungszeit, daß kein Kurzschluß mehr vorliegt, so gibt sie kein Signal an die Logik 130 weiter. Das Signal OFF von der Verzögerung 160 führt dazu, daß das Schaltmittel 110 in seinen geöffneten Zustand übergeht.

Die Verzögerungszeit von ca. 100 Mikrosekunden bewirkt, daß bei kurzzeitigen Spannungseinbrüchen oder Kurzschlüssen keine Abschaltung erfolgt. Kurzfristige Spannungseinbrüche treten insbesondere bei kapazitiven oder induktiven Lasten auf. Üblicherweise ist vorgesehen, daß beim nächsten Ansteuersignal das Schaltmittel wie im Normalbetrieb betätigt wird.

Zusätzlich oder alternativ kann vorgesehen, daß der Strom, der durch das Schaltmittel 110 fließt, mittels des Strommeßwiderstandes 120 erfaßt wird. Die Strombegrenzung 180 steuert das Schaltmittel 110 derart an, daß der Strom nicht über einen höchstzulässigen Wert ansteigt.

Treten die Ansteuersignale IN kurz hintereinander auf, kann bei einer solchen Einrichtung der Fall eintreten, daß eine sehr hohe Verlustleistung in der Endstufe oder in dem Schaltmittel 110 erzeugt wird. Dies Verlustleistung kann zu einer thermischen Zerstörung oder wenigstens einer thermischen Beschädigung der Endstufe 110 führen. Erfindungsgemäß ist deshalb vorgesehen, daß ein erkannter Kurzschluß eine adaptiv angepaßte Ansteuerpause zur Folge hat.

Dies wird beispielsweise dadurch realisiert, daß mittels des Kurzschlußzählers 150 die auftretenden Kurzschlüsse gezählt werden. Beim ersten Einschalten der Endstufe ist dieser Zähler auf 0 gesetzt. Jedes Einschaltsignal IN führt zu einem Einschalten der Endstufe.

Tritt nun bei einem Einschaltvorgang ein Kurzschluß auf, so wird der Kurzschlußzähler inkrementiert. Die Logik 130 unterdrückt eine bestimmte Anzahl von Ansteuerimpulsen. Die Zahl der unterdrückten Ansteuersignale wird durch den Inhalt

KSZ des Kurzschlußzählers bestimmt. Beispielsweise gibt die Logik 130 das Ansteuersignal erst mit dem 2 ^{KSZ} ten Ansteuerimpuls wieder frei. Liegt dann immer noch ein Kurzschluß vor, so wird der Inhalt KSZ des Kurzschlußzählers weiter inkrementiert, bis er einen definierten oberen Wert KSZmax. erreicht hat. Dies bedeutet, daß die Einschaltpausen abhängig von der Zeit, die der Kurzschluß anliegt, zunehmen. Effektiv bedeutet dies eine Zurücknahme der mittleren Verlustleistung bevor die Temperatur der Endstufe unzulässig hoch ansteigen kann.

Liegt nach einem Wiedereinschalten kein Kurzschluß mehr vor, so wird der Kurzschlußzähler 150 auf 0 zurückgesetzt. Das Schaltmittel 110 folgt wieder dem Ansteuersignal IN.

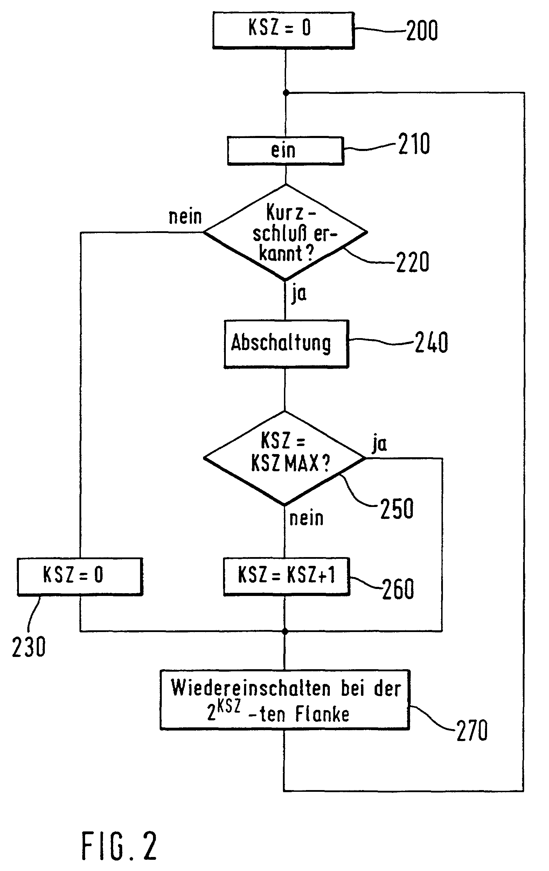

In Figur 2 wird diese Vorgehensweise detailliert an Hand eines Flußdiagrammes dargestellt. In einem ersten Programmschritt 200 wird beim Einschalten des Steuergeräts und/oder der Endstufe der Kurzschlußzähler KSZ auf 0 gesetzt. Anschließend in Schritt 210 folgt ein Ansteuersignal IN, das die Endstufe einschaltet, d. h. der Schalter 110 geschlossen wird und der Stromfluß freigegeben ist. Die anschließende Abfrage 220 überprüft, ob ein Kurzschluß vorliegt. Dies erfolgt beispielsweise durch die Kurzschlußerkennung 170. Wird kein Kurzschluß erkannt, so folgt der Schritt 230, in dem der Kurzschlußzähler KSZ auf 0 gesetzt wird.

Erkennt die Abfrage 220 einen Kurzschluß, so gibt die Logik 130 in Schritt 240 ein solches Ansteuersignal ab, das die Endstufe abschaltet, d. h. das Schaltmittel 110 den Stromfluß unterbricht. Bei einem erkannten Kurzschluß wird der Stromfluß durch den Verbraucher unterbunden.

Die anschließende Abfrage 250 überprüft, ob der Inhalt des Kurzschlußzählers KSZ größer oder gleich dem Maximalwert KSZMAX ist. Ist dies nicht der Fall, so wird im Schritt 260 der Kurzschlußzähler KSZ um 1 erhöht. Erkennt die Abfrage das der Maximalwert KSZMAX erreicht ist, so folgt der Schritt 270. Dieser folgt auch im Anschluß an den Schritt 230 und den Schritt 260. Im Schritt 270 wird nach Ablauf von 2^{KSZ} Ansteuerimpulsen das Signal an das Schaltmittel 110 freigegeben. Dies bedeutet, daß bei einem erkannten Kurzschluß eine vorgegebene Anzahl von nachfolgenden Ansteuerungen des Verbrauchers unterbunden wird.

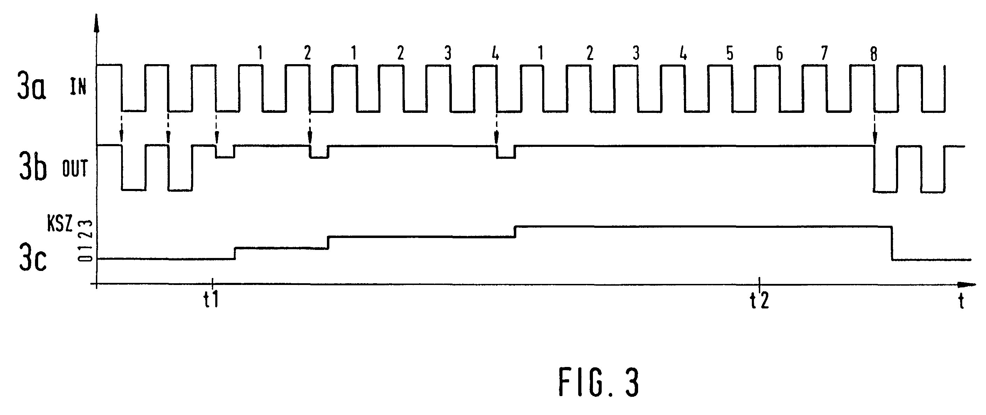

In Figur 3 sind verschiedene Signale über Zeit t aufgetragen. In Figur 3a ist das Ausgangssignal des Mikroprozessors IN, in Figur 3b ist der Schaltzustand des Schaltmittels 110 und in Figur 3c ist der Inhalt des Kurzschlußzählers KSZ aufgetragen. In dem dargestellten Ausführungsbeispiel gibt der Mikroprozessor 140 das Ansteuersignal IN in festen Zeitabständen mit einer festen Periodendauer vor. Sobald das Signal IN von seinem hohen Pegel auf seinem niederen Pegel abfällt, geht das Schaltmittel 110 von seinem nichtleitenden in seinen leitenden Zustand über.

Zum Zeitpunkt t1 tritt ein Kurzschluß auf, dies hat zur Folge, daß bei dem nächsten Impuls, das heißt der nächsten abfallenden Flanke des Signals IN der Kurzschluß erkannt wird. Die Logik steuert das Schaltmittel 110 so an, daß das Schaltmittel 110 in seinem gesperrten Zustand übergeht. Gleichzeitig wird der Kurzschlußzähler auf den Wert 1 erhöht. Dies bedeutet, das Schaltmittel wird bei dem zweiten folgenden Impuls wieder in seinen geschlossenen Zustand überführt. Zu diesem Zeitpunkt liegt der Kurzschluß noch vor, die Kurzschlußerkennung erkennt weiterhin auf Kurzschluß und der Kurzschlußzähler wird auf 2 erhöht. Nach dem 4. Impuls wird das Schaltmittel 110 wieder in seinen geschlossenen Zustand übergeführt, in dem dargestellten Ausführungsbeispiel liegt der Kurzschluß noch vor, was erkannt wird und das Schaltmittel 110 wird in seinen gesperrten Zustand gebracht. Gleichzeitig wird der Kurzschlußzähler auf 3 erhöht.

Zum Zeitpunkt t2 entfällt der Kurzschluß, dies hat zur Folge, daß beim 8. Impuls das Schaltmittel 110 in seinem leitenden Zustand verbleibt. Da kein Kurzschluß mehr vorliegt, wird der Kurzschlußzähler auf 0 zurückgesetzt. Ab diesem Zeitpunkt erfolgt die übliche Ansteuerung des Schaltmittels 110.

Bei einem erkannten Kurzschluß wird der Stromfluß durch den Verbraucher unterbunden. Bei einer vorgebbaren Anzahl von nachfolgenden Ansteuerungen bleibt der Stromfluß durch den Verbraucher unterbunden. Die Anzahl der unterbundenen Steuerungen hängt dabei von der Dauer des Kurzschlusses ab. Je länger der Kurzschluß anhält, desto mehr Ansteuerungen werden unterbunden.

Bei einer Ausgestaltung der Erfindung kann auch vorgesehen sein, daß anstelle einer Anzahl von Ansteuerungen die Ansteuersignale für eine vorgebbare Zeitdauer unterbunden werden. Dies bedeutet, daß bei einem erkannten Kurzschluß für eine vorgebbare Dauer die nachfolgenden Ansteuerungen unterbunden werden.

Eine solche Vorgehensweise ist insbesondere dann vorteilhaft, wenn die Ansteuerimpulse unregelmäßig auftreten, wie dies beispielsweise bei Magnetventilen, die in Bremssystemen eingesetzt werden, der Fall ist.

## Patentansprüche

1. Verfahren zur Ansteuerung eines Verbrauchers in einem Kraftfahrzeug, wobei ein Schaltmittel und der Verbraucher in Reihe zwischen einer Versorgungsspannung und einer Masse geschaltet sind, wobei ein Kurzschluss des Verbrauchers gegen Masse und/oder Versorgungsspannung erkannt wird, **dadurch gekennzeichnet, dass** bei einem erkannten Kurzschluss ein Wert eines Kurzschlusszählers erhöht wird eine vorgebbare Anzahl von nachfolgenden Ansteuerungen unterbunden wird, wobei die Anzahl der unterbundenen Ansteuerungen abhängig vom Wert des Kurzschlusszählers vorgebbar ist.

2. Vorrichtung zur Ansteuerung eines Verbrauchers, wobei ein Schaltmittel und der Verbraucher in Reihe zwischen einer Versorgungsspannung und einer Masse geschaltet sind, mit Mitteln, die einen Kurzschluss des Verbrauchers gegen Masse und/oder Versorgungsspannung erkennen, **dadurch gekennzeichnet, dass** Mittel vorgesehen sind, die bei einem erkannten Kurzschluss einen Wert eines Kurzschlusszählers erhöhen, eine vorgebbare Anzahl von nachfolgenden Ansteuerungen unterbinden, wobei die Anzahl der unterbundenen Ansteuerungen abhängig vom Wert des Kurzschlusszählers vorgebbar ist.

## Claims

1. Method for actuating a load in a motor vehicle, the switching means and the load being connected in series between a supply voltage and an earth, a short-circuit of the load to earth and/or supply voltage being detected, **characterized in that** when a short-circuit is detected a value of a short-circuit counter is incremented and a predefinable number of subsequent actuations are prohibited, it being possible to predefine the number of prohibited actuations as a function of the value of the short-circuit counter.

2. Device for actuating a load, a switching means and the load being connected in series between a supply voltage and an earth, having means which detect a short-circuit of the load to earth and/or supply voltage, **characterized in that** means are provided which increment a value of a short-circuit counter when a short-circuit is detected and prohibit a predefinable number of subsequent actuations, it being possible to predefine the number of prohibited actuations as a function of the value of the short-circuit counter.

## Revendications

1. Procédé pour commander un consommateur dans un véhicule automobile, dont un moyen de commutation et le consommateur sont connectés en série entre une tension d'alimentation et une masse, selon lequel un court-circuit du consommateur à la masse et/ou à la tension d'alimentation est détecté,
**caractérisé en ce qu'**
en cas de détection d'un court-circuit, une valeur d'un compteur de courts-circuits est augmentée, un nombre prédéterminable de commandes suivantes est bloqué, le nombre des commandes bloquées pouvant être prédéterminé en fonction de la valeur du compteur de courts-circuits.

2. Dispositif pour la commande d'un consommateur, un moyen de commutation et le consommateur étant connectés en série entre une tension d'alimentation et une masse, comprenant des moyens qui détectent un court-circuit de la charge avec la masse et/ou avec la tension d'alimentation,
**caractérisé par**
des moyens qui, en cas de détection d'un court-circuit, augmentent une valeur d'un compteur de courts-circuits, bloquent un nombre prédéterminable de commandes suivantes, le nombre des commandes bloquées pouvant être prédéterminé en fonction de la valeur du compteur de courts-circuits.
